# EUROPEAN PATENT APPLICATION

(11) **EP 4 265 339 A1**
(43) Date of publication of application: **25.10.2023**
(21) Application number: 20965952.3
(22) Date of filing: 17.12.2020
(51) Int. Cl.: B05C 1/02, H05K 3/34

(54) **TRANSFER PIN AND TRANSFER DEVICE**

(71) Applicant: Fuji Corporation, Chiryu-shi, Aichi 472-8686 (JP)
(72) Inventor: IMURA Jinya, Chiryu-shi, Aichi 472-8686 (JP); MIYAJIMA Takashi, Chiryu-shi, Aichi 472-8686 (JP)
(74) Representative: Grünecker Patent- und Rechtsanwälte PartG mbB
(86) International application number: PCT/JP2020/047142
(87) International publication number: WO 2022/130564

(57) **Abstract**

A transfer pin includes a main body portion, and a releasing portion formed on a tip end side of the main body portion, and configured to, when a solder paste including a solder ball is dipped and transferred to a mounting portion of a component of a board, release the solder paste from a tip end portion of the main body portion.

## Description

### Technical Field

The present specification discloses a technology related to a transfer pin and a transfer device.

### Background Art

Multiple crest-shaped protrusions are provided at a tip end portion of a transfer pin described in Patent Literature 1. In addition, Patent Literature 1 discloses that various shapes such as a hemisphere shape, a flat shape, a trapezoidal shape, and a recessed portion shape can be adopted as the shape of a protrusion provided at the tip end portion of the transfer pin, rather than being limited to the crest shape. The invention described in Patent Literature 1 is made to adjust an adhered amount of a liquid and an amount of a liquid applied on a workpiece by changing the shape and the size of the transfer pin.

Patent Literature 2 discloses a comparison result of the applied state of a high viscosity material in a case where a tip angle of a transfer pin is changed from 30° to 180°. In addition, Patent Literature 2 discloses a transfer pin in which a tip end portion is sharpened into a pyramid shape or a cone shape. Patent Literature 3 discloses a transfer pin having a small diameter on a tip end side, a transfer pin having a changed curvature of a tip end portion, a transfer pin having a flat-shaped tip end portion, a transfer pin whose tip end portion is a part of a spherical surface, and the like.

### Patent Literature

Patent Literature 1: JP-A-H10-066911
Patent Literature 2: JP-A-2005-000776
Patent Literature 3: JP-A-2002-134896

### Summary of the Invention

### Technical Problem

Since a solder ball in a solder paste is very soft, there is a possibility that the solder ball is crushed during the dipping and transferring of the solder paste, causing the solder paste to be deposited on the transfer pin. When the solder paste is deposited on the transfer pin, there is a possibility that the transfer shape of the solder paste varies when the solder paste is transferred to a mounting portion of a component of a board. In this case, the transfer pin needs to be cleaned frequently, which may make continuous transfer for a long time difficult.

In addition, in order to suppress the crushing of the solder ball, it is conceivable to improve the accuracy of a position control (height control) of the transfer pin during the dipping and transferring of the solder paste. However, in order to suppress the crushing of the solder ball, a position control (height control) of a 10 µm level is required during the dipping and transferring of the solder paste, so that the position control (height control) of the transfer pin may be advanced and complicated.

In view of such circumstances, the present specification discloses a transfer pin and a transfer device capable of suppressing the crushing of the solder ball during the dipping and transferring of the solder paste.

### Solution to Problem

The present specification discloses a transfer pin including a main body portion, and a releasing portion formed on a tip end side of the main body portion, and configured to, when a solder paste including a solder ball is dipped and transferred to a mounting portion of a component of a board, release the solder paste from a tip end portion of the main body portion.

In addition, the present specification discloses a transfer device including the transfer pin in which the main body portion is formed integrally with the tip end portion in a shape that tapers from a base end portion toward the tip end portion, and a selection section configured to, in a case where a film thickness of the solder paste accommodated in a container is constant, select the transfer pin having a larger taper angle of the main body portion as a transfer diameter of the solder paste to be transferred increases.

Further, the present specification discloses a transfer device including the transfer pin in which the main body portion is formed integrally with the tip end portion in a shape that tapers from a base end portion toward the tip end portion, and a setting section configured to, in a case where a taper angle of the main body portion is constant, set a film thickness of the solder paste accommodated in a container to be thicker as a transfer diameter of the solder paste to be transferred increases.

### Advantageous Effect of the Invention

With the transfer pin described above, since the releasing portion is provided, the solder paste can be released from the tip end portion of the main body portion during the dipping and transferring of the solder paste, so that the solder ball can be suppressed from being crushed during the dipping and transferring of the solder paste. The above description of the transfer pin can be similarly applied to a transfer device including the transfer pin.

### Brief Description of Drawings

Fig. 1 is a plan view illustrating a configuration example of a component mounter.
Fig. 2 is a side view illustrating an example of a positional relationship among a container, a mounting head, and a transfer pin.
Fig. 3 is a perspective view illustrating an example of a transfer pin in a reference form.
Fig. 4 is a schematic view illustrating an example of a solder paste deposited on the transfer pin of Fig. 3.
Fig. 5 is a perspective view illustrating an example of the transfer pin.
Fig. 6 is a perspective view illustrating another example of the transfer pin.
Fig. 7 is a side view illustrating the transfer pin as viewed in a direction of the arrow VII in Fig. 6.
Fig. 8 is a plan view illustrating the transfer pin as viewed in a direction of the arrow VIII in Fig. 6.
Fig. 9 is a schematic view illustrating an example of the relationship between the shape of a tip end portion and the shape of a mounting portion which are formed in the transfer pin.
Fig. 10 is a schematic view illustrating another example of the relationship between the shape of the tip end portion and the shape of the mounting portion which are formed in the transfer pin.
Fig. 11 is a block diagram illustrating an example of a control block of a transfer device.
Fig. 12A is a schematic view illustrating an example of the shape of the solder paste held by the tip end portion when a taper angle of a main body portion of the transfer pin is 20°.
Fig. 12B is a schematic view illustrating an example of the shape of the solder paste held by the tip end portion when a taper angle of the main body portion of the transfer pin is 100°.
Fig. 13 is a schematic view illustrating an example of the relationship between a taper angle of the main body portion of the transfer pin and a diameter of the solder paste dipped into the tip end portion.
Fig. 14A is a perspective view illustrating an example of the transfer pin in which a taper angle of the main body portion is 15°.
Fig. 14B is a perspective view illustrating an example of the transfer pin in which a taper angle of the main body portion is 60°.
Fig. 14C is a perspective view illustrating an example of the transfer pin in which a taper angle of the main body portion is 100°.
Fig. 15A is a distribution diagram illustrating an example of the relationship between the number of times of dipping and transferring and a transfer diameter of the solder paste.
Fig. 15B is a distribution diagram illustrating another example of the relationship between the number of times of dipping and transferring and a transfer diameter of the solder paste.
Fig. 16A is a schematic view illustrating an example of the shape of the solder paste held by the tip end portion when a film thickness of the solder paste is 60 µm.
Fig. 16B is a schematic view illustrating an example of the shape of the solder paste held by the tip end portion when a film thickness of the solder paste is 200 µm.
Fig. 17A is a schematic view illustrating an example of the relationship between a film thickness of the solder paste and a diameter of the solder paste dipped into the tip end portion.
Fig. 17B is a schematic view illustrating another example of the relationship between a film thickness of the solder paste and a diameter of the solder paste dipped into the tip end portion.

### Description of Embodiments

### 1. Embodiments

### 1-1. Configuration Example of Component Mounter 10

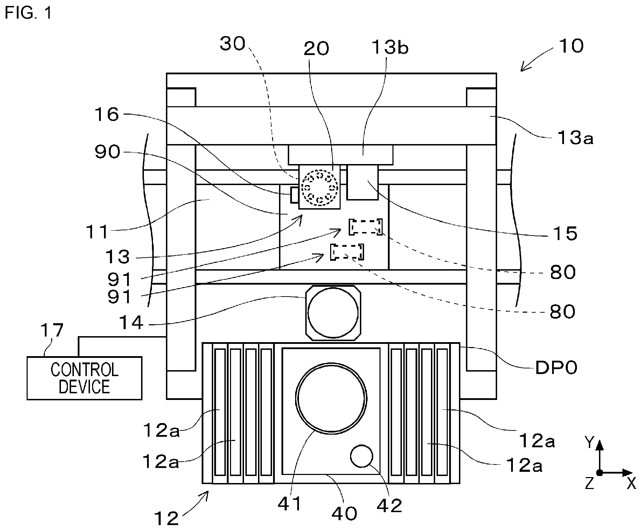

Component mounter 10 mounts multiple components 80 on board 90. As illustrated in Fig. 1, component mounter 10 of the present embodiment includes board conveyance device 11, component supply device 12, component transfer device 13, part camera 14, board camera 15, side camera 16, and control device 17.

For example, board conveyance device 11 includes a belt conveyor, and conveys board 90 in a conveyance direction (X-axis direction). Board 90 is a circuit board, and various circuits such as an electronic circuit, an electrical circuit, and a magnetic circuit are formed. Board conveyance device 11 conveys board 90 into component mounter 10, and positions and clamps board 90 at a predetermined position in component mounter 10. After a mounting process of multiple components 80 by component mounter 10 is completed, board conveyance device 11 unclamps board 90 and conveys board 90 out of component mounter 10.

Component supply device 12 supplies multiple components 80 to be mounted on board 90. Component supply device 12 includes multiple feeders 12a, which are provided along the conveyance direction (X-axis direction) of board 90. Each of multiple feeders 12a pitch-feeds a carrier tape in which multiple components 80 are housed, and supplies component 80 to be picked up at a supply position located on the tip end side of feeder 12a. In addition, component supply device 12 can also supply a relatively large electronic component (for example, a lead component or the like) as compared with a chip component or the like in a state of being disposed on a tray. Multiple feeders 12a and the tray are provided to be detachable (exchangeable) from pallet member DP0.

Component transfer device 13 includes head driving device 13a and moving body 13b. Head driving device 13a is configured to move moving body 13b in the X-axis direction and a Y-axis direction (a direction orthogonal to the X-axis direction on a horizontal plane) by a linear motion mechanism. Mounting head 20 is provided to be detachable (exchangeable) from moving body 13b by a clamp member. Mounting head 20 uses at least one holding member 30 to pick up and hold component 80 supplied by component supply device 12, and mounts component 80 on board 90 positioned by board conveyance device 11. For example, a suction nozzle, a chuck, or the like can be used for holding member 30.

As part camera 14, board camera 15, and side camera 16, a well-known imaging device can be used. Part camera 14 is fixed to a base of component mounter 10 in such a manner that an optical axis thereof is oriented upwards in a vertical direction (in a Z-axis direction orthogonal to the X-axis direction and the Y-axis direction). Part camera 14 can capture an image of component 80 held by holding member 30 from below. Board camera 15 is provided on moving body 13b of component transfer device 13 in such a manner that an optical axis thereof is oriented downwards in the vertical direction (Z-axis direction). Board camera 15 can capture an image of board 90 from above.

Side camera 16 is provided on mounting head 20 in such a manner that an optical axis thereof is oriented in a horizontal direction. Side camera 16 can capture an image of component 80 or the like held by holding member 30 from the side (horizontal direction). Part camera 14, board camera 15, and side camera 16 capture an image based on a control signal sent out from control device 17. Image data of images captured by part camera 14, board camera 15, and side camera 16 are transmitted to control device 17.

Control device 17 includes a well-known arithmetic device and a storage device, and a control circuit is configured therein. Information, image data, and the like outputted from various sensors provided in component mounter 10 are inputted to control device 17. Control device 17 sends out a control signal to each device based on a control program, a predetermined mounting condition set in advance, and the like.

For example, control device 17 causes board camera 15 to capture an image of board 90 positioned by board conveyance device 11. Control device 17 performs image processing on the image captured by board camera 15 to recognize a positioning state of board 90. In addition, control device 17 causes holding member 30 to pick up and hold component 80 supplied by component supply device 12 and causes part camera 14 and side camera 16 to capture an image of component 80 held by holding member 30. Control device 17 performs image processing on the image captured by part camera 14 and side camera 16 to recognize a holding posture of component 80.

Control device 17 moves holding member 30 towards a position lying above a mounting planned position set in advance by a control program or the like. In addition, control device 17 corrects the mounting planned position based on the positioning state of board 90, the holding posture of component 80, and the like to set a mounting position on which component 80 is actually mounted. The mounting planned position and the mounting position include a rotation angle in addition to the position (X-axis coordinate and Y-axis coordinate).

Control device 17 corrects a target position (X-axis coordinate and Y-axis coordinate) and a rotation angle of holding member 30 in accordance with the mounting position. Control device 17 lowers holding member 30 at the corrected rotation angle at the corrected target position, and mounts component 80 on board 90. Control device 17 executes a mounting process for mounting multiple components 80 on board 90 by repeating the pick-and-place cycle described above.

### 1-2. Dipping and Transferring of Solder Paste 40p

A printer applies solder paste 40p to mounting portion 91 of component 80 of board 90. Mounting portion 91 is a portion electrically connected to an electrode of component 80, and is also referred to as a pad. However, in the printer, for example, there may be a case where applying solder paste 40p to a region on which component 80 is already mounted is difficult. In addition, in the printer, as the unevenness of board 90 increases, it becomes difficult to apply solder paste 40p to board 90.

Further, in the printer, there is a case where applying multiple types of solder pastes 40p to one board 90 is difficult. Solder paste 40p can also be applied by a dispenser. However, it is difficult to apply a small amount of solder paste 40p below the minimum application amount of the dispenser. Therefore, component mounter 10 of the present embodiment is provided with dip unit 40 and transfer pin 50.

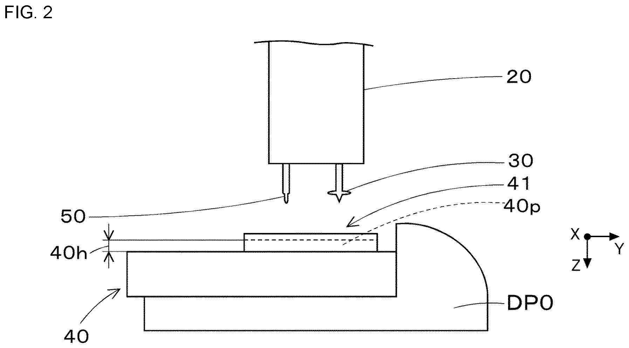

As illustrated in Figs. 1 and 2, dip unit 40 includes container 41 and storage tank 42. Container 41 accommodates solder paste 40p. Container 41 of the present embodiment is formed in a bottomed cylindrical shape. Dip unit 40 periodically rotates container 41 so that solder paste 40p in container 41 does not locally decrease. In addition, dip unit 40 detects a remaining amount of solder paste 40p while container 41 rotates. When the remaining amount of solder paste 40p becomes equal to or less than a predetermined amount, dip unit 40 replenishes solder paste 40p from storage tank 42 in which solder paste 40p is stored to container 41. In addition, dip unit 40 can also adjust film thickness 40h of solder paste 40p.

Dip unit 40 is provided to be detachable (exchangeable) from pallet member DP0. As illustrated in Fig. 1, pallet member DP0 may be provided with multiple feeders 12a and dip unit 40 simultaneously. Pallet member DP0 may be provided with a tray and dip unit 40 simultaneously. As described above, in the present embodiment, dip unit 40 including container 41 is provided exchangeably with component supply device 12 that supplies component 80. Therefore, component mounter 10 can be easily downsized in comparison with a case where an installation space of container 41 is separately provided. In addition, the maintenance of container 41 is facilitated.

As illustrated in Fig. 2, in mounting head 20, at least one holding member 30 is exchanged with transfer pin 50. Transfer pin 50 provided in mounting head 20 is moved in the horizontal direction (X-axis direction and Y-axis direction) by mounting head 20 in the same manner as holding member 30, and is lifted and lowered in the vertical direction (Z-axis direction). As described above, board 90 is positioned by board conveyance device 11. Transfer pin 50 provided in mounting head 20 is moved in the horizontal direction (X-axis direction and Y-axis direction) between container 41 and the positioned board 90, and is lifted and lowered in the vertical direction (Z-axis direction).

Control device 17 drives and causes mounting head 20 to dip transfer pin 50 provided in mounting head 20 into solder paste 40p accommodated in container 41. Next, control device 17 drives and causes mounting head 20 to move transfer pin 50 to mounting portion 91 of component 80 of board 90. Then, control device 17 drives and causes mounting head 20 to transfer solder paste 40p held by transfer pin 50 to mounting portion 91. Control device 17 can apply solder paste 40p to multiple mounting portions 91 by repeating the driving and controlling of mounting head 20 described above.

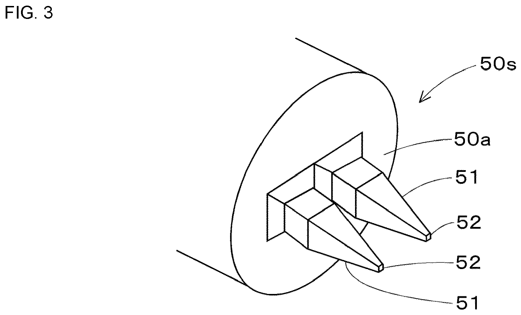

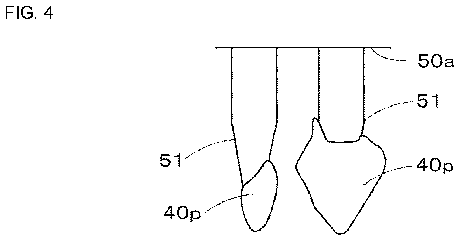

For example, as illustrated in Fig. 3, it is assumed that tip end portion 52 is transfer pin 50s having a flat shape (in Fig. 3, a square having a side of 50 µm). Tip end portion 52 having a flat shape comes into surface contact with a solder ball in solder paste 40p during the dipping and transferring of solder paste 40p. Since the solder ball is very soft, there is a possibility that the solder ball is crushed during the dipping and transferring of solder paste 40p in transfer pin 50s illustrated in Fig. 3, causing solder paste 40p to be deposited on transfer pin 50s as illustrated in Fig. 4.

Fig. 4 illustrates an example of the state of transfer pin 50s after 3000 times of transfer. In this manner, when solder paste 40p is deposited on transfer pin 50s by repeating the transfer of solder paste 40p, the transfer shape of solder paste 40p may vary when solder paste 40p is transferred to mounting portion 91 of component 80 of board 90. In this case, transfer pin 50s needs to be cleaned frequently, which may make continuous transfer for a long time difficult.

In addition, in order to suppress the crushing of the solder ball, it is conceivable to improve the accuracy of a position control (height control) of transfer pin 50s during the dipping and transferring of solder paste 40p. However, in order to suppress the crushing of the solder ball, a position control (height control) of a 10 µm level is required during the dipping and transferring of solder paste 40p, so that the position control (height control) of transfer pin 50s may be advanced and complicated. Therefore, in the present embodiment, transfer pin 50 is used.

### 1-3. Configuration Example of Transfer Pin 50

Transfer pin 50 of the present embodiment includes main body portion 51 and releasing portion 53. Releasing portion 53 is formed on the tip end side of main body portion 51, and releases solder paste 40p from tip end portion 52 of main body portion 51 when solder paste 40p including the solder ball is dipped and transferred to mounting portion 91 of component 80 of board 90.

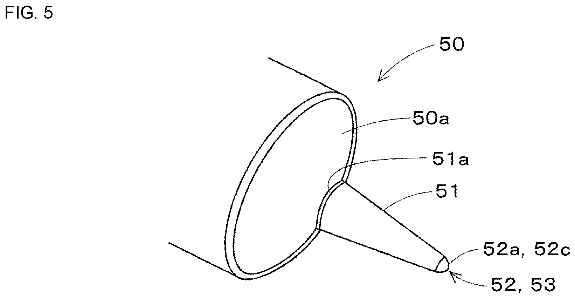

Releasing portion 53 may have various forms as long as solder paste 40p can be released from tip end portion 52 of main body portion 51 during the dipping and transferring of solder paste 40p. Releasing portion 53 illustrated in Fig. 5 is tip end portion 52 formed in hemisphere 52a shape. Tip end portion 52 having hemisphere 52a shape comes into point contact with the solder ball in solder paste 40p during the dipping and the transferring of solder paste 40p.

Therefore, tip end portion 52 having hemisphere 52a shape can easily release solder paste 40p from tip end portion 52 of main body portion 51 during the dipping and transferring of solder paste 40p in comparison with tip end portion 52 having a flat shape, so that the solder ball can be suppressed from being crushed. The particle diameter of solder paste 40p suitable for use in pin transfer is approximately 1 µm to 25 µm in general. Therefore, a radius of hemisphere 52a may be set to 50 µm or less.

Since tip end portion 52 illustrated in Fig. 5 is shaped as hemisphere 52a, the transfer shape of solder paste 40p becomes a circular shape. Therefore, transfer pin 50 illustrated in Fig. 5 is suitable for a case where mounting portion 91 has a circular shape or a square shape. However, the shape of mounting portion 91 is not limited to a circular shape or a square shape.

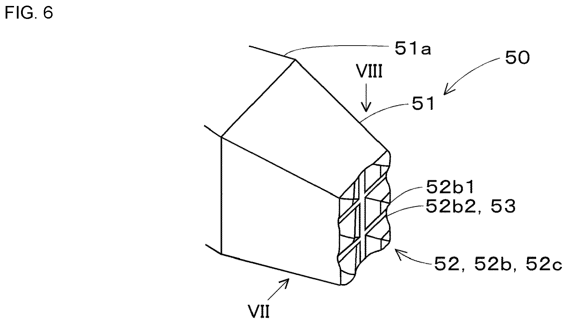

Tip end portion 52 illustrated in Fig. 6 is formed in hump 52b shape in which crest portions 52b1 having a protrusion shape and valley portions 52b2 as releasing portion 53 are formed at a constant pitch. In tip end portion 52 having hump 52b shape, crest portion 52b1 having a protrusion shape comes into point contact with the solder ball in solder paste 40p during the dipping and transferring of solder paste 40p. In addition, tip end portion 52 having hump 52b shape includes valley portion 52b2 that is releasing portion 53. Therefore, tip end portion 52 having hump 52b shape can easily release solder paste 40p from tip end portion 52 of main body portion 51 during the dipping and transferring of solder paste 40p in comparison with tip end portion 52 having a flat shape, so that the solder ball can be suppressed from being crushed.

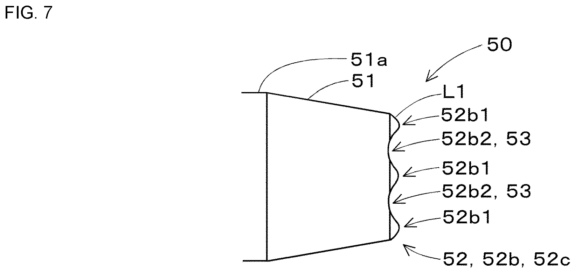

Tip end portion 52 having hump 52b shape can be formed by a known method. For example, tip end portion 52 having hump 52b shape can be formed by wire electric discharge machining, laser machining, grinding, or the like. As illustrated in Fig. 7, in the wire electric discharge machining, a wire as an electrode moves along curve L1 in a state in which a machining material is immersed in a machining liquid (pure water). At this time, an electric discharge is generated between the non-contact machining material and the wire, and thus the machining material is melted, and is cut along curve L1.

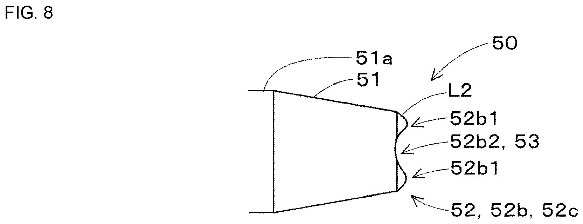

Next, as illustrated in Fig. 8, a wire as an electrode moves along curve L2 in a state in which a machining material is immersed in a machining liquid (pure water). At this time, an electric discharge is generated between the non-contact machining material and the wire, and thus the machining material is melted, and is cut along curve L2. As a result, tip end portion 52 having hump 52b shape illustrated in Fig. 6 is formed. Transfer pin 50 illustrated in Fig. 6 can correspond to various shapes of mounting portion 91 by setting the number and the arrangement of crest portions 52b1 and valley portions 52b2 in accordance with the shapes of mounting portion 91.

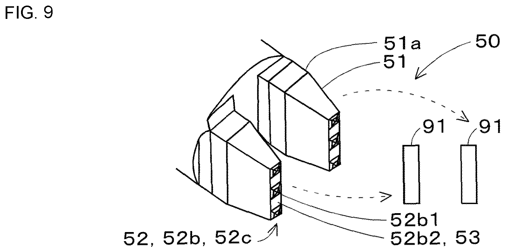

Fig. 9 illustrates an example of the relationship between the shape of tip end portion 52 and the shape of mounting portion 91 which are formed in transfer pin 50. A region having hump 52b shape in tip end portion 52 of transfer pin 50 illustrated in Fig. 9 has a rectangular shape. Specifically, three crest portions 52b1 and two valley portions 52b2 are linearly formed. Therefore, transfer pin 50 illustrated in Fig. 9 is suitable for a case where mounting portion 91 has a rectangular shape. In Fig. 9, multiple (two in Fig. 9) transfer pins 50 are provided on one pedestal portion 50a. The interval between multiple (two) transfer pins 50 is set in accordance with the interval between multiple (two) mounting portions 91. Therefore, as indicated by dashed arrows, transfer pin 50 illustrated in Fig. 9 can simultaneously transfer solder paste 40p to multiple (two) mounting portions 91.

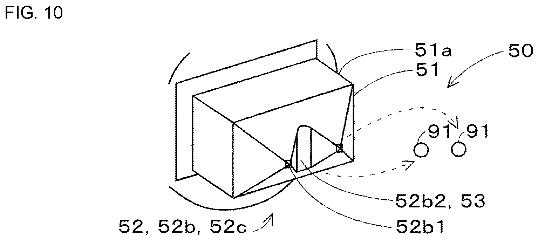

Fig. 10 illustrates another example of the relationship between the shape of tip end portion 52 and the shape of mounting portion 91 which are formed in transfer pin 50. Tip end portion 52 of transfer pin 50 illustrated in Fig, 10 is formed with a region having hump 52b shape in accordance with multiple (two) adjacent mounting portions 91. Specifically, each of multiple (two) mounting portions 91 has a circular shape. In addition, in tip end portion 52 of transfer pin 50 illustrated in Fig. 10, two crest portions 52b1 and one valley portion 52b2 are linearly formed. The interval between two crest portions 52b1 is set in accordance with the interval between multiple (two) mounting portions 91. Therefore, as indicated by dashed arrows, transfer pin 50 illustrated in Fig. 10 can simultaneously transfer solder paste 40p to multiple (two) mounting portions 91.

The height from valley portion 52b2 to crest portion 52b1 (the depth of tip end portion 52 having hump 52b shape) illustrated in Fig. 10 is set higher in comparison with the height from valley portion 52b2 to crest portion 52b1 (the depth of tip end portion 52 having hump 52b shape) in each of multiple (two) transfer pins 50 illustrated in Fig. 9. As a result, in the transfer pin 50 illustrated in Fig. 10, a short circuit between multiple (two) adjacent mounting portions 91 is suppressed.

Tip end portion 52 of transfer pin 50 abuts on the bottom portion of container 41 during the dipping of solder paste 40p, and abuts on mounting portion 91 of component 80 of board 90 during the transferring of solder paste 40p. Therefore, tip end portion 52 of transfer pin 50 is easily worn. When tip end portion 52 of transfer pin 50 is worn, there is a possibility that the transfer shape of solder paste 40p varies. In this case, transfer pin 50 needs to be maintained, which may make continuous transfer for a long time difficult.

Therefore, in any of transfer pins 50 described above, coating 52c of diamond-like carbon may be formed on tip end portion 52. By forming coating 52c of diamond-like carbon (DLC: Diamond Like Carbon) on tip end portion 52, the hardness of tip end portion 52 is improved, and the wear of tip end portion 52 of transfer pin 50 is reduced. The thickness of coating 52c can be set to approximately 1 µm.

### 1-4. Configuration Example of Transfer Device 60

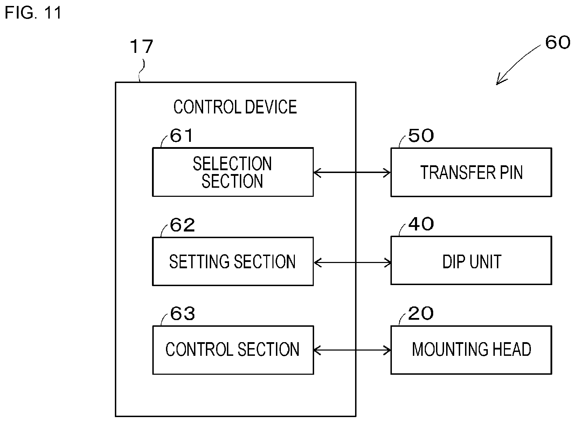

Transfer device 60 includes transfer pin 50 and selection section 61. In addition, transfer device 60 may also include transfer pin 50 and setting section 62. In addition, transfer device 60 may also include control section 63. Selection section 61, setting section 62, and control section 63 may be provided in various control devices and management devices. Selection section 61, setting section 62, and control section 63 may be formed on a cloud. As illustrated in Fig. 11, in the present embodiment, selection section 61, setting section 62, and control section 63 are provided in control device 17 of component mounter 10.

Transfer pin 50 may be in any of the forms described above. In transfer pin 50 described above, main body portion 51 is formed integrally with tip end portion 52 in a shape that tapers from base end portion 51a toward tip end portion 52. Specifically, main body portion 51 of transfer pin 50 illustrated in Fig. 5 is formed in a truncated cone shape. Main body portion 51 of transfer pin 50 illustrated in Figs. 6, 9, and 10 is formed in a truncated square pyramid shape. In a case where solder paste 40p is dipped into transfer pin 50 including main body portion 51 described above, the shape of solder paste 40p held by tip end portion 52 changes depending on taper angle 51t of main body portion 51.

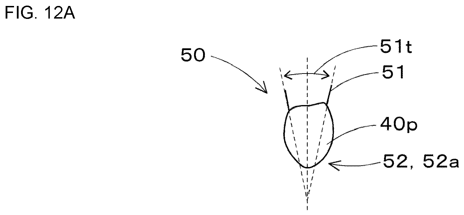

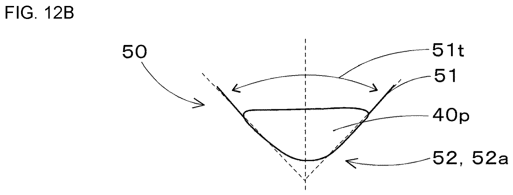

As illustrated in Figs. 12A and 12B, solder paste 40p at tip end portion 52 is held in a dropped shape by the surface tension. For example, in transfer pin 50 illustrated in Fig. 12A, taper angle 51t of main body portion 51 is set to 20°. In transfer pin 50 illustrated in Fig. 12B, taper angle 51t of main body portion 51 is set to 100°. Transfer pin 50 illustrated in Fig. 12B has a larger diameter of the drop and a larger transfer diameter of solder paste 40p to be transferred in comparison with transfer pin 50 illustrated in Fig. 12A.

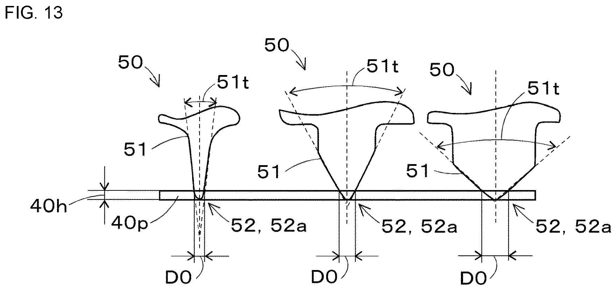

Fig. 13 illustrates an example of the relationship between taper angle 51t of main body portion 51 of transfer pin 50 and diameter D0 of solder paste 40p dipped into tip end portion 52. Film thickness 40h of solder paste 40p accommodated in container 41 is constant at 125 µm. In addition, tip end portion 52 of transfer pin 50 is formed in hemisphere 52a shape, and a radius of hemisphere 52a is 50 µm.

In transfer pin 50 on the left side in Fig. 13, taper angle 51t of main body portion 51 is set to 15°. Diameter D0 of solder paste 40p dipped into tip end portion 52 when abutting tip end portion 52 of transfer pin 50 on the bottom surface of container 41 was 121 µm. When solder paste 40p was transferred to mounting portion 91, the transfer diameter (diameter) of solder paste 40p was approximately the target of 180 µm.

In central transfer pin 50 in Fig. 13, taper angle 51t of main body portion 51 is set to 60°. Diameter D0 of solder paste 40p dipped into tip end portion 52 when abutting tip end portion 52 of transfer pin 50 on the bottom surface of container 41 was 202 µm. When solder paste 40p was transferred to mounting portion 91, the transfer diameter (diameter) of solder paste 40p was approximately the target of 220 µm.

In transfer pin 50 on the right side in Fig. 13, taper angle 51t of main body portion 51 is set to 100°. Diameter D0 of solder paste 40p dipped into tip end portion 52 when abutting tip end portion 52 of transfer pin 50 on the bottom surface of container 41 was 334 µm. When solder paste 40p is transferred to mounting portion 91, the transfer diameter (diameter) of solder paste 40p is approximately the target of 350 µm.

As described above, in a case where film thickness 40h of solder paste 40p accommodated in container 41 is constant, the diameter of the drop of solder paste 40p held by tip end portion 52 increases as taper angle 51t of main body portion 51 increases. As a result, the transfer diameter of solder paste 40p to be transferred increases. Therefore, in a case where film thickness 40h of solder paste 40p accommodated in container 41 is constant, selection section 61 selects transfer pin 50 having a larger taper angle 51t of main body portion 51 as the transfer diameter of solder paste 40p to be transferred increases.

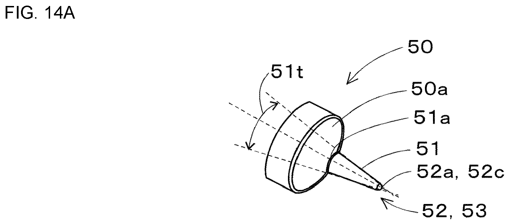

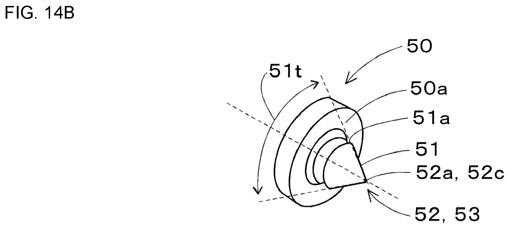

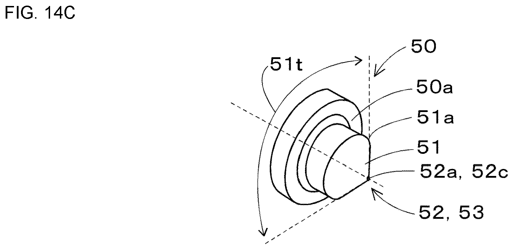

In transfer pin 50 illustrated in Fig. 14A, taper angle 51t of main body portion 51 is set to 15°. In transfer pin 50 illustrated in Fig. 14B, taper angle 51t of main body portion 51 is set to 60°. In transfer pin 50 illustrated in Fig. 14C, taper angle 51t of main body portion 51 is set to 100°. For example, in a case where the target of the transfer diameter (diameter) of solder paste 40p is 180 µm, selection section 61 selects transfer pin 50 illustrated in Fig. 14A in which taper angle 51t of main body portion 51 is set to 15°.

In a case where the target of the transfer diameter (diameter) of solder paste 40p is 220 µm, selection section 61 selects transfer pin 50 illustrated in Fig. 14B in which taper angle 51t of main body portion 51 is set to 60°. In a case where the target of the transfer diameter (diameter) of solder paste 40p is 350 µm, selection section 61 selects transfer pin 50 illustrated in Fig. 14C in which taper angle 51t of main body portion 51 is set to 100°.

As a result, in a case where film thickness 40h of solder paste 40p accommodated in container 41 is constant, selection section 61 can select appropriate transfer pin 50 according to the transfer diameter of solder paste 40p to be transferred. The relationship between taper angle 51t of main body portion 51 and the transfer diameter (diameter) of solder paste 40p may be derived in advance by simulation, verification with an actual machine, or the like.

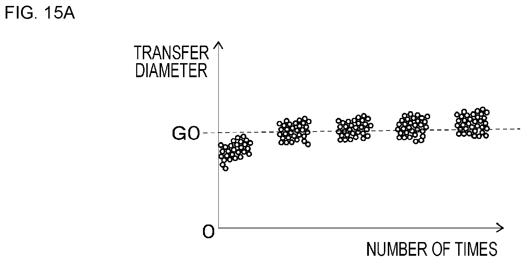

As illustrated in Fig. 15A, in a case where dipping and transferring are repeated multiple times on one transfer pin 50, the transfer diameter of solder paste 40p to be transferred may not be constant from the first time. Fig. 15A illustrates an example of the relationship between the number of times of dipping and transferring and the transfer diameter of solder paste 40p. The horizontal axis in Fig. 15A represents the number of times of dipping and transferring, and the vertical axis represents the transfer diameter (diameter) of solder paste 40p. Circles represent measurement results.

As illustrated in Fig. 15A, when the number of times of dipping and transferring is small, the transfer diameter (diameter) of solder paste 40p is smaller than target value G0. As the number of times of dipping and transferring increases, the transfer diameter (diameter) of solder paste 40p increases, and thus the transfer diameter of solder paste 40p reaches target value G0 and is constant at target value G0. This phenomenon tends to occur as taper angle 51t of main body portion 51 decreases, such as transfer pin 50 illustrated in Fig. 12A. In transfer pin 50 in which taper angle 51t of main body portion 51 is relatively small, when the number of times of dipping and transferring is small, solder paste 40p easily remains at tip end portion 52 of transfer pin 50, so that all solder paste 40p to be transferred may not be completely transferred.

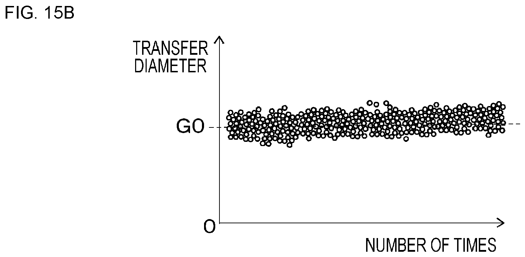

On the other hand, as illustrated in Fig. 15B, in a case where dipping and transferring are repeated multiple times on one transfer pin 50, the transfer diameter of solder paste 40p to be transferred may be constant from the first time. Fig. 15B illustrates another example of the relationship between the number of times of dipping and transferring and a transfer diameter of solder paste 40p. The horizontal axis in Fig. 15B represents the number of times of dipping and transferring, and the vertical axis represents the transfer diameter (diameter) of solder paste 40p. Circles represent measurement results.

As illustrated in Fig. 15B, the transfer diameter (diameter) of solder paste 40p is constant at target value G0 from the first time. This phenomenon tends to occur as taper angle 51t of main body portion 51 increases, such as transfer pin 50 illustrated in Fig. 12B. In transfer pin 50 in which taper angle 51t of main body portion 51 is relatively large, when the number of times of dipping and transferring is small, solder paste 40p hardly remains on tip end portion 52 of transfer pin 50, so that all solder paste 40p to be transferred is easily completely transferred.

Therefore, in a case where dipping and transferring are repeated multiple times on one transfer pin 50, selection section 61 may select transfer pin 50 in which taper angle 51t of main body portion 51 is set so that the transfer diameter of solder paste 40p to be transferred is constant from the first time. For example, it is assumed that when taper angle 51t of main body portion 51 is 15° to 20°, the transfer diameter (diameter) of solder paste 40p is approximately the target of 180 µm. In addition, it is assumed that when taper angle 51t of main body portion 51 is 15°, the transfer diameter of solder paste 40p is not constant from the first time, and when taper angle 51t of main body portion 51 is 20°, the transfer diameter of solder paste 40p is constant from the first time.

In this case, selection section 61 selects transfer pin 50 in which taper angle 51t of main body portion 51 is set to 20°. As a result, selection section 61 can select appropriate transfer pin 50 where the transfer diameter (diameter) of solder paste 40p is constant from the first time, and transfer pin 50 can transfer solder paste 40p with the target transfer diameter from the first time. The above description can be similarly applied to other taper angles 51t. In addition, the relationship between the number of times of dipping and transferring, the transfer diameter (diameter) of solder paste 40p, and taper angle 51t of main body portion 51 may be derived in advance by simulation, verification with an actual machine, or the like.

In addition, in a case where solder paste 40p is dipped into transfer pin 50 including main body portion 51 formed integrally with tip end portion 52 in a shape that tapers from base end portion 51a toward tip end portion 52, the shape of solder paste 40p held by tip end portion 52 changes depending on film thickness 40h of solder paste 40p accommodated in container 41. However, taper angle 51t of main body portion 51 is constant.

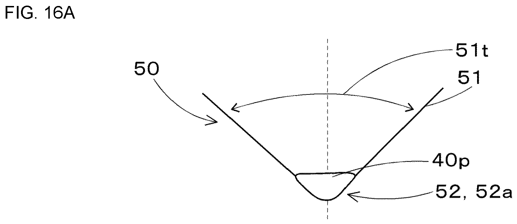

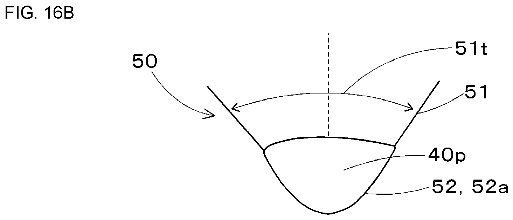

For example, in transfer pin 50 illustrated in Figs. 16A and 16B, taper angle 51t of main body portion 51 is set to 100°. Tip end portion 52 of transfer pin 50 illustrated in Figs. 16A and 16B is formed in hemisphere 52a shape, and a radius of hemisphere 52a is 50 µm. Transfer pin 50 illustrated in Fig. 16A illustrates a state in which solder paste 40p having film thickness 40h of 60 µm is dipped into transfer pin 50. Transfer pin 50 illustrated in Fig. 16B illustrates a state in which solder paste 40p having film thickness 40h of 150 µm is dipped into transfer pin 50.

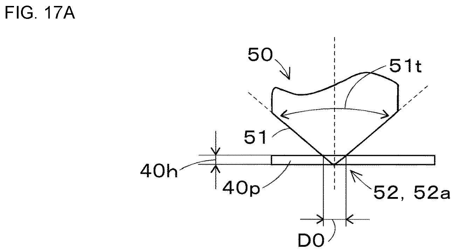

Fig. 17A illustrates an example of the relationship between film thickness 40h of solder paste 40p and a diameter of solder paste 40p dipped into tip end portion 52. In transfer pin 50 illustrated in Figs. 16A and 17A, diameter D0 of solder paste 40p dipped into tip end portion 52 was 179 µm. When solder paste 40p was transferred to mounting portion 91, the transfer diameter (diameter) of solder paste 40p was approximately the target of 200 µm.

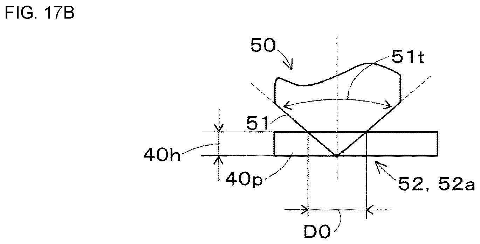

Fig. 17B illustrates another example of the relationship between film thickness 40h of solder paste 40p and a diameter of solder paste 40p dipped into tip end portion 52. In transfer pin 50 illustrated in Figs. 16B and 17B, diameter D0 of solder paste 40p dipped into tip end portion 52 was 394 µm. When solder paste 40p was transferred to mounting portion 91, the transfer diameter (diameter) of solder paste 40p was approximately the target of 400 µm.

As described above, in a case where taper angle 5 1t of main body portion 51 is constant, the diameter of the drop of solder paste 40p held by tip end portion 52 increases as film thickness 40h of solder paste 40p accommodated in container 41 is thicker. As a result, the transfer diameter of solder paste 40p to be transferred increases. Therefore, in a case where taper angle 51t of main body portion 51 is constant, setting section 62 sets film thickness 40h of solder paste 40p accommodated in container 41 to be thicker as the transfer diameter of solder paste 40p to be transferred increases.

For example, in a case where the target of the transfer diameter (diameter) of solder paste 40p is 200 µm, setting section 62 sets film thickness 40h of solder paste 40p accommodated in container 41 to 60 µm. In addition, in a case where the target of the transfer diameter (diameter) of solder paste 40p is 400 µm, setting section 62 sets film thickness 40h of solder paste 40p accommodated in container 41 to 150 µm.

As a result, in a case where taper angle 51t of main body portion 51 is constant, setting section 62 can set appropriate film thickness 40h of solder paste 40p according to the transfer diameter of solder paste 40p to be transferred. The relationship between film thickness 40h of solder paste 40p and the transfer diameter (diameter) of solder paste 40p may be derived in advance by simulation, verification with an actual machine, or the like.

Control section 63 simultaneously transfers solder paste 40p to multiple mounting portions 91 using at least one transfer pin 50 provided in pedestal portion 50a. As a result, component mounter 10 can shorten the production time of the board product in comparison with a case where solder paste 40p is sequentially transferred to each of multiple mounting portions 91. For example, in Fig. 9, multiple (two in Fig. 9) transfer pins 50 are provided on one pedestal portion 50a. The interval between multiple (two) transfer pins 50 is set in accordance with the interval between multiple (two) mounting portions 91. In this case, control section 63 can simultaneously transfer solder paste 40p to multiple (two) mounting portions 91 using multiple (two) transfer pins 50.

In addition, in tip end portion 52 of transfer pin 50 illustrated in Fig. 10, a region having hump 52b shape is formed in accordance with multiple (two) adjacent mounting portions 91. Specifically, each of multiple (two) mounting portions 91 has a circular shape. In addition, in tip end portion 52 of transfer pin 50 illustrated in Fig. 10, two crest portions 52b1 and one valley portion 52b2 are linearly formed. The interval between two crest portions 52b1 is set in accordance with the interval between multiple (two) mounting portions 91. In this case, control section 63 can simultaneously transfer solder paste 40p to multiple (two) mounting portions 91 using one transfer pin 50.

In any case, control section 63 drives and causes mounting head 20 to dip transfer pin 50 provided in mounting head 20 into solder paste 40p accommodated in container 41. Next, control section 63 drives and causes mounting head 20 to move transfer pin 50 to multiple (two) mounting portions 91. Then, control section 63 drives and causes mounting head 20 to transfer solder paste 40p held by transfer pin 50 to multiple (two) mounting portions 91.

### 2. Example of Advantage of Embodiment

With transfer pin 50, since releasing portion 53 is provided, solder paste 40p can be released from tip end portion 52 of main body portion 51 during the dipping and transferring of solder paste 40p, so that the solder ball can be suppressed from being crushed during the dipping and transferring of solder paste 40p. The above description of transfer pin 50 can be similarly applied to transfer device 60 including transfer pin 50.

### Reference Signs List

40p: solder paste, 40h: film thickness, 41: container, 50: transfer pin, 50a: pedestal portion, 51: main body portion, 51a: base end portion, 51t: taper angle, 52: tip end portion, 52a: hemisphere, 52b: hump, 52b1: crest portion, 52b2: valley portion, 52c: coating, 53: releasing portion, 60: transfer device, 61: selection section, 62: setting section, 63: control section, 80: component, 90: board, 91: mounting portion

## Claims

1. A transfer pin comprising:
a main body portion; and
a releasing portion formed on a tip end side of the main body portion, and configured to, when a solder paste including a solder ball is dipped and transferred to a mounting portion of a component of a board, release the solder paste from a tip end portion of the main body portion.

2. The transfer pin according to Claim 1,
wherein the releasing portion is the tip end portion formed in a hemisphere shape.

3. The transfer pin according to Claim 1,
wherein the tip end portion is formed in a hump shape in which a crest portion having a protrusion shape and a valley portion as the releasing portion are formed at a constant pitch.

4. The transfer pin according to any one of Claims 1 to 3,
wherein a coating of diamond-like carbon is formed on the tip end portion.

5. A transfer device comprising:
the transfer pin according to any one of Claims 1 to 4, in which the main body portion is formed integrally with the tip end portion in a shape that tapers from a base end portion toward the tip end portion; and
a selection section configured to, in a case where a film thickness of the solder paste accommodated in a container is constant, select the transfer pin having a larger taper angle of the main body portion as a transfer diameter of the solder paste to be transferred increases.

6. The transfer device according to Claim 5,
wherein the selection section is configured to, in a case where dipping and transferring are repeated multiple times on one transfer pin, select the transfer pin in which the taper angle of the main body portion is set so that the transfer diameter of the solder paste to be transferred is constant from the first time.

7. A transfer device comprising:
the transfer pin according to any one of Claims 1 to 4, the main body portion being formed integrally with the tip end portion in a shape that tapers from a base end portion toward the tip end portion; and
a setting section configured to, in a case where a taper angle of the main body portion is constant, set a film thickness of the solder paste accommodated in a container to be thicker as a transfer diameter of the solder paste to be transferred increases.

8. The transfer device according to any one of Claims 5 to 7, further comprising a control section configured to simultaneously transfer the solder paste to the multiple mounting portions using at least one transfer pin provided on a pedestal portion.
